Europäisches Patentamt

European Patent Office

Office européen des brevets

(19)

(11) Veröffentlichungsnummer: **0 280 922 B1**

(12) **EUROPÄISCHE PATENTSCHRIFT**

(45) Veröffentlichungstag der Patentschrift: **21.08.91**    (51) Int. Cl.5: **G03F 7/18**

(21) Anmeldenummer: **88101763.6**

(22) Anmeldetag: **06.02.88**

(54) **Verfahren zum nahtlosen und haftfesten Verbinden der End- und/oder Seitenbereiche von lichtempfindlichen Schichten sowie Verwendung der so verbundenen lichtempfindlichen Schichten für die Herstellung von Druckformen.**

(30) Priorität: **14.02.87 DE 3704693**

(43) Veröffentlichungstag der Anmeldung:
**07.09.88 Patentblatt 88/36**

(45) Bekanntmachung des Hinweises auf die
Patenterteilung:
**21.08.91 Patentblatt 91/34**

(84) Benannte Vertragsstaaten:
**BE DE FR GB IT NL**

(56) Entgegenhaltungen:
**FR-A- 803 918**
**FR-A- 2 391 072**
**NL-A- 8 501 052**

(73) Patentinhaber: **BASF Aktiengesellschaft**
**Carl-Bosch-Strasse 38**
**W-6700 Ludwigshafen(DE)**

(72) Erfinder: **Wallbillich, Guenter, Dr.**
**Erschigweg 19**
**W-6730 Neustadt(DE)**
Erfinder: **van Heuvelen, Jan Hendrik**
**Hogeweg 123**
**NL-7502 CC Losser(NL)**

**Beschreibung**

Die Erfindung betrifft ein Verfahren zum nahtlosen und haftfesten Verbinden der End- und/oder Seitenbereiche von einer oder mehreren thermoplastisch verarbeitbaren lichtempfindlichen Schichten, wie sie beispielsweise für die Herstellung von Druckformen, insbesondere Flexodruckformen oder auch Tiefdruckformen, Verwendung finden, unter dem Einfluß von Wärme und Druck unter Ausbildung einer durchgehend verbundenen lichtempfindlichen Schicht mit glatter, gleichmäßiger Oberfläche. Die Erfindung betrifft des weiteren die Verwendung der so hergestellten nahtlos und haftfest verbundenen, glatten, gleichmäßigen lichtempfindlichen Schichten für die Herstellung von Druckformen, insbesondere für den Rotationsdruck.

Die Herstellung von Relief- und Druckformen mittels lichtempfindlicher Schichten ist an sich bekannt. Die hierfür üblicherweise eingesetzten lichtempfindlichen Schichten sind im allgemeinen photopolymerisierbar und/oder photovernetzbar und enthalten in der Regel neben einem polymeren Bindemittel mindestens eine photopolymerisierbare und/oder photovernetzbare Verbindung, einen Photoinitiator sowie weitere Zusatz- und/oder Hilfsstoffe, wobei sich Art und Menge der Bestandteile nach dem Verwendungszweck der lichtempfindlichen Schichten richten. Wegen der leichten und einfachen Verarbeitbarkeit werden hierbei vielfach thermoplastisch verarbeitbare lichtempfindliche Schichten verwendet. Zur Herstellung der Relief- oder Druckformen werden die auf einem Träger oder Substrat aufgebrachten lichtempfindlichen Schichten bildmäßig mit aktinischem Licht belichtet und anschließend in geeigneter Weise, beispielsweise durch Auswaschen mit einem Entwicklerlösungsmittel, entwickelt. Je nach dem, ob die lichtempfindliche Schicht negativ oder positiv arbeitend ist, werden bei der Entwicklung der Relief- oder Druckformen die unbelichteten oder belichteten Bereiche der Schicht entfernt.

Für eine Reihe von Anwendungszwecken, insbesondere beim Rotationsdruck, ist es notwendig, eine lichtempfindliche Schicht für die Herstellung einer Druckform oder die daraus bereits hergestellte Druckschicht auf einen Formzylinder oder eine Formzylinder-Hülse ("Sleeve") aufzuspannen oder aufzukleben. Dabei stoßen nach der Umwicklung des Zylinders oder der Zylinderhülse die Endabschnitte der Schicht unter Ausbildung eines Spaltes oder einer Nahtstelle aneinander. Werden zum Belegen von großen Formzylindern oder Formzylinder-Hülsen mehrere lichtempfindliche Schichten hinter- und/oder nebeneinander angeordnet, so stoßen deren End- und/oder Seitenabschnitte unter Ausbildung von Nahtstellen aneinander. Beim Arbeiten mit so belegten Formzylindern oder Formzylinder-Hülsen treten eine Reihe von Schwierigkeiten auf: Zum einen sind die Nahtstellen zwischen den End- und/oder Seitenabschnitten der einzelnen Schichten im Druckbild sichtbar, so daß hiermit kein Rollendruck, d.h. kein Druck eines fortlaufenden Endlosmusters, möglich ist. Zum anderen führt die in diesen Nahtstellen eindringende Druckfarbe beim Drucken zum Spritzen und unter Umständen auch zu einer Lösung der Verklebung der Druckschicht(en) auf dem Formzylinder bzw. der Formzylinder-Hülse. Beim Tiefdruck können diese Nahtstellen ferner den Rakellauf erheblich stören und dadurch zu einer Beschädigung der Rakel und/oder der Druckschicht führen.

Das Verbinden der End- und/oder Seitenbereiche von aufgespannten Druckplatten unter Ausfüllen der dazwischen gebildeten Spalte oder Nahtstellen mit einer Verschlußmasse, wie es beispielsweise in der DE-A-25 45 618 oder EP-A-118 866 für die Herstellung von Tiefdruckzylindern beschrieben ist, vermag wohl einige dieser Probleme zu lösen, läßt sich jedoch nicht ohne weiteres für die Herstellung von Tiefdruckzylindern oder -zylinderhülsen für den Endlosdruck anwenden. Außerdem ist es für die Herstellung von Hochdruckformen ungeeignet.

Es ist auch schon vorgeschlagen worden, insbesondere für die Herstellung von Hochdruckformen für den Endlosdruck, einen Druckzylinder mit einer lichtempfindlichen polymeren Schicht zu umwickeln und die dabei aneinander stoßenden Endabschnitte unter dem Einfluß von Wärme und Druck nahtlos miteinander zu verbinden. Hierzu sei beispielsweise auf die DE-A-27 22 896, DE-A-28 44 426, DE-A-28 42 440, DE-A-29 11 908, EP-B-40 893, EP-A-43 623 und EP-A-111 371 verwiesen. Bei diesen bekannten Verfahren werden die für die Herstellung der Druckformen eingesetzten lichtempfindlichen Schichten so auf den Umfang der zu belegenden Zylinder oder Zylinder-Hülsen zugeschnitten, daß beim Umwickeln der Zylinder bzw. Zylinder-Hülsen mit der lichtempfindlichen Schicht deren Endkanten, ohne zu überlappen oder einen Trennspalt zu bilden, aneinanderstoßen. Die so aneinanderstoßenden Endbereiche der lichtempfindlichen Schicht werden dann unter einem auf ihre Oberfläche gerichteten Druck so lange einer Wärmebehandlung unterzogen, bis sie fest miteinander verschweißt sind. Neben dem Erfordernis des genauen Zuschnitts der lichtempfindlichen Schichten bringen diese bekannten Verfahrensweisen weitere teils schwerwiegende Nachteile mit sich. So kommt es beim Einsatz von Kalandrierwalzen zur Druckerzeugung (DE-A-27 22 896, DE-A-28 44 426) häufig zu einer Beschädigung der lichtempfindlichen Schicht durch die Kalanderwalze. Insbesondere ist aber die ausgebildete Schweißnaht nur relativ schwach und mechanisch wenig beanspruchbar.

Eine formgebende mechanische Nachbehandlung der nach den bekannten Verfahren verschweißten lichtempfindlichen Schichten, beispielsweise durch Abdrehen, Abspänen, Schleifen oder dergleichen, wie sie in aller Regel bei konisch zulaufenden Druckzylinder-Hülsen nach dem Belegen mit einer lichtempfindlichen Schicht notwendig und erforderlich ist, ist daher nur schlecht oder gar nicht möglich.

Aufgabe der vorliegenden Erfindung war es daher, ein einfaches Verfahren zum nahtlosen und haftfesten Verbinden der End- und/oder Seitenbereiche von thermoplastisch verarbeitbaren lichtempfindlichen Schichten zur Erzeugung einer durchgehenden lichtempfindlichen Schicht mit gleichmäßiger, glatter Oberfläche aufzuzeigen, die sich für die Herstellung von Druckformen, insbesondere für den Tiefdruck oder Flexodruck, eignet. Das Verfahren soll variabel und breit anwendbar sein und weitgehende Freiheit bezüglich Form und Anzahl der zu verarbeitenden lichtempfindlichen Schichten gewähren. Das Verfahren soll dabei insbesondere zum Beschichten von Formzylindern oder Formzylinder-Hülsen, vornehmlich auch konisch zulaufenden Formzylinder-Hülsen, mit einer nahtlosen, durchgehenden, gleichmäßigen lichtempfindlichen Schicht für die Herstellung von Druckformen für den Rotationsdruck geeignet sein.

Es wurde nun überraschend gefunden, daß diese Aufgabe gelöst wird durch ein Verfahren, bei dem die End- und/oder Seitenbereiche von lösungsmittelfreien und trägerfreien thermoplastisch verarbeitbaren lichtempfindlichen Schichten blasenfrei überlappend so zusammengelegt werden, daß im Überlappungsbereich praktisch kein Lufthohlraum zwischen den End- bzw. Seitenbereichen gebildet wird, danach die gesamte Schichtmasse unter der Einwirkung von Druck erwärmt wird, wodurch die überlappenden End- und/oder Seitenbereiche haftfest miteinander verbunden werden, und anschließend die so erhaltene durchgehend verbundene lichtempfindliche Schicht unter maßgenauer Formgebung nachbehandelt und geglättet wird.

Gegenstand der Erfindung ist dementsprechend ein Verfahren zum nahtlosen und haftfesten Verbinden der End- und/oder Seitenbereiche von thermoplastisch verarbeitbaren lichtempfindlichen Schichten unter dem Einfluß von Wärme und Druck, welches dadurch gekennzeichnet ist, daß die End- und/oder Seitenbereiche von einer bzw. mehreren im wesentlichen lösungsmittelfreien und trägerfreien lichtempfindlichen Schichten blasenfrei unter Verdrängung der Luft zwischen den End- bzw. Seitenbereichen überlappend zusammengelegt werden, danach die gesamte Schichtmasse unter Druck und Verbinden der sich überlappenden End- und/oder Seitenbereiche erwärmt und die so erhaltene durchgehend verbundene lichtempfindliche Schicht unter maßgenauer Formgebung nachbehandelt und geglättet wird.

Das erfindungsgemäße Verfahren ist einfach und leicht durchführbar und erlaubt aufgrund der vielfachen möglichen Ausführungs- und Ausgestaltungsformen eine breite und allgemeine Anwendung. Überraschenderweise lassen sich mit dem erfindungsgemäßen Verfahren mechanisch beständige und beanspruchbare, durchgehende, gleichmäßige und homogene lichtempfindliche Schichten erhalten, die sich auf einer entsprechenden Unterlage problemlos durch bildmäßiges Belichten und Entwickeln zu Druckformen oder auch sonstigen Reliefformen beliebiger Art verarbeiten lassen. Das erfindungsgemäße Verfahren läßt nicht nur die Verarbeitung von dünnen lichtempfindlichen Schichten zu, sondern eignet sich auch hervorragend für das Verbinden von dicken lichtempfindlichen Schichten, beispielsweise mit Schichtdicken bis zu einigen mm.

Für den Einsatz in dem erfindungsgemäßen Verfahren kommen beliebige thermoplastisch verarbeitbare, feste lichtempfindliche Schichten in Betracht, die unter dem Einfluß von Wärme und Druck miteinander verbunden werden können, ohne daß hierdurch ihre lichtempfindlichen Eigenschaften beeinträchtigt werden. Hierzu gehören insbesondere die festen, polymeren, lichtempfindlichen Schichten, die bei Erwärmung erweichen und unter Druck verfließen bzw. verkleben, wie sie für die Herstellung von Druck- und Reliefformen an sich bekannt sind. Neben photoabbaubaren Systemen sind hier vor allem die positiv oder negativ arbeitenden, lichtempfindlichen photopolymerisierbaren Schichten zu nennen. Geeignete photopolymerisierbare Schichten enthalten im allgemeinen mindestens ein thermoplastisch verarbeitbares polymeres Bindemittel, wie z.B. lösliche Polyamide, teilverseifte Polyvinylacetate, weichgemachte Polyvinylalkohole oder Polyvinylalkohol-Derivate, Polyurethane, Dienpolymerisate, wie z.B. Blockcopolymerisate aus Styrol, Butadien und/oder Isopren oder Butadien/Acrylnitril-Copolymerisate, mindestens eine niedermolekulare, ethylenisch ungesättigte, photopolymerisierbare Verbindung, wie z.B. die bekannten (Meth)acrylat- oder (Meth)-acrylamido-Gruppen enthaltenden Monomeren, mindestens einen Photopolymerisationsinitiator wie z.B. Benzoinether, Benzilmonoketale oder Acylphosphinoxide, sowie übliche Zusatz- und/oder Hilfsstoffe, wie z.B. thermische Polymerisationsinhibitoren, Farbstoffe, Pigmente, Füllstoffe, Weichmacher, Verlaufshilfsmittel, sensitometrische Regler etc.. Insbesondere kommen für das erfindungsgemäße Verfahren die lichtempfindlichen photopolymerisierbaren Schichten in Betracht, wie sie für die Herstellung von Flexodruckformen oder Tiefdruckformen bekannt und beschrieben sind (vgl. z.B. DE-A-22 15 090, DE-A-29 02 412, EP-B-27 612, DE-A-20 61 287, EP-A-70 510, EP-A-70 511). Die Dicke der einzusetzenden lichtempfindlichen Schichten ist bei dem erfindungsgemäßen Verfahren unkritisch und kann, wie erwähnt, in weiten Grenzen variiert werden. Üblicherweise liegt die Schichtdicke im Bereich von etwa 100 bis etwa 1.500 μm.

Die in dem erfindungsgemäßen Verfahren einzusetzenden thermoplastisch verarbeitbaren lichtempfindlichen Schichten sollen lösungsmittelfrei und trägerfrei sein. Lösungsmittelfrei bedeutet dabei im Rahmen dieser Erfindung, daß die einzusetzenden lichtempfindlichen Schichten keine wesentliche Menge eines Lösungsmittels, beispielsweise von ihrer Herstellung her, enthalten sollen. Gleichwohl können die einzusetzenden lichtempfindlichen Schichten eine geringe Restmenge an Lösungsmittel, beispielsweise unter 5 Gew.%, insbesondere unter 2 Gew.%, bezogen auf die lichtempfindliche Schicht, aufweisen. Wesentlich ist, daß der Lösungsmittelgehalt der erfindungsgemäß einzusetzenden lichtempfindlichen Schichten so gering ist, daß diese unter den Verarbeitungsbedingungen in dem erfindungsgemäßen Verfahren nicht gasen. Vorteilhafterweise geht man daher für das erfindungsgemäße Verfahren von solchen lichtempfindlichen Schichten aus, die lösungsmittelfrei durch Kneten, Extrudieren, Kalandrieren, Pressen etc. hergestellt worden sind.

Um ein haftfestes Verschmelzen bzw. Verkleben der übereinanderliegenden End- und/oder Seitenbereiche der lichtempfindlichen Schichten in dem erfindungsgemäßen Verfahren unter Ausbildung einer durchgehenden homogenen Schicht zu ermöglichen, versteht es sich von selbst, daß die erfindungsgemäß einzusetzenden lichtempfindlichen Schichten trägerfrei sind. Vorzugsweise, aber nicht zwingendermaßen, kommen daher in dem erfindungsgemäßen Verfahren selbsttragende lichtempfindliche Schichten zum Einsatz. Es ist auch möglich, daß die einzusetzenden lichtempfindlichen Schichten zunächst auf einem temporären Träger, beispielsweise einer Kunststoff-Folie, aufgebracht sind, der dann unmittelbar vor dem Einsatz der lichtempfindlichen Schichten in dem erfindungsgemäßen Verfahren, z.B. durch Abziehen, entfernt wird.

Die in dem erfindungsgemäßen Verfahren einzusetzenden trägerfreien lichtempfindlichen Schichten können an sich jede beliebige Form aufweisen, solange sie sich in ihren zu verbindenden Randbereichen überlappend zusammenlegen lassen. Damit entfällt die Notwendigkeit eines exakten Zuschnitts der zu verbindenden lichtempfindlichen Schichten. Die lichtempfindlichen Schichten können beispielsweise quadratisch, rechteckig, trapezförmig, parallelogrammförmig etc. sein und haben in der Regel platten-, band- oder streifenförmige Gestalt. Ebenso ist die Ausprägung der Kanten und Kantenstrukturen in den zu verbindenden End- und/oder Seitenbereichen der lichtempfindlichen Schichten grundsätzlich beliebig gestaltbar. So können die Kanten z.B. ungeradlinig verlaufen, in der Regel sind sie jedoch geradlinig. Die Kanten der zu verbindenden End- und/oder Seitenbereiche der lichtempfindlichen Schichten können senkrecht zur Schichtoberfläche verlaufen. Sie können aber auch abgeflacht bzw. abgeschrägt sein und beispielsweise keilförmig zulaufen. Die letztgenannte Ausführungsform, gemäß der lichtempfindliche Schichten eingesetzt werden, deren zu verbindende End- und/oder Seitenbereiche keilförmig abgeschrägte Kanten aufweisen, hat sich gleichermaßen bei Einsatz dünner als auch dicker lichtempfindlicher Schichten als vorteilhaft erwiesen. Dabei können an den zu verbindenden Stellen eine oder beide Kanten der überlappend zusammengelegten End- oder Seitenbereiche der lichtempfindlichen Schicht bzw. Schichten keilförmig abgeschrägt zulaufen, wobei es sich als besonders günstig herausgestellt hat, wenn mindestens die jeweils unten liegende Kante in den überlappend zusammengelegten End- oder Seitenbereichen entsprechend abgeschrägt ist. In einer weiteren, besonders vorteilhaften Ausgestaltung dieser Ausführungsform wird die lichtempfindliche Schicht bzw. werden die lichtempfindlichen Schichten beim überlappenden Zusammenlegen der zu verbindenden End- und/oder Seitenbereiche dabei so angeordnet, daß bei der in dem überlappenden Bereich unten liegenden Kante des betreffenden End- oder Seitenbereichs die keilförmige Abschrägung von der darüber liegenden Schicht weg nach unten hin gerichtet ist. Selbstverständlich sind dabei unter den vorstehend beschriebenen Ausgestaltungsformen bezüglich Schichtform, Kantenverlauf und Abschrägung die verschiedensten Kombinationen möglich.

Da das erfindungsgemäße Verfahren zum haftfesten Verbinden der End- und/oder Seitenbereiche von lichtempfindlichen Schichten unter dem Einfluß von Druck erfolgt, werden die lichtempfindlichen Schichten zum Verbinden ihrer End-und/oder Seitenbereiche zunächst am besten auf eine feste, insbesondere formstabile Unterlage aufgebracht. Die Oberfläche dieser Unterlage kann eben oder gewölbt, glatt oder auch rauh bzw. strukturiert sein, um beispielsweise eine bessere Haftung zwischen lichtempfindlicher Schicht und Unterlage zu erzielen. Vorzugsweise werden als Unterlage von vornherein solche Materialien eingesetzt, die mit den lichtempfindlichen Schichten belegt werden sollen und nach dem haftfesten Verbinden der End- und/oder Seitenbereiche der lichtempfindlichen Schichten gleichzeitig als Träger für die erhaltene durchgehend verbundene lichtempfindliche Schicht dienen.

Je nach Art und Form der Unterlage werden die lichtempfindlichen Schichten zum Verbinden ihrer End- und/oder Seitenbereiche auf diese entweder einfach aufgelegt oder aber vorzugsweise in geeigneter Weise hierauf fixiert. Das Fixieren kann dabei z.B. rein mechanisch oder vorteilhaft mittels eines Haftlackes, eines doppelseitigen Klebebandes, eines Schmelzklebers oder dergleichen erfolgen. Auch wenn die Form der Unterlage im allgemeinen nicht kritisch ist, werden hierfür insbesondere Platten, Zylinder, zylindrische oder konisch zulaufende Rohre bzw. Hülsen eingesetzt. Insbesondere hat sich das erfindungsgemäße Verfahren als sehr geeignet erwiesen zum Beschichten von Formzylindern und Formzylinder-Hülsen, insbesondere auch konisch zulaufenden Formzylinder-Hülsen, wie sie unter anderem beim Rotationsdruck zur Anwendung gelangen, mit einer durchgehenden nahtlosen lichtempfindlichen Schicht.

Als Materialien für die Unterlage kommen unter anderem Metalle, Kunststoffe, glasfaserverstärkte Kunststoffe und dergleichen in Betracht, ebenso wie beschichtete Materialien, wie z.B. metallische Zylinder oder metallische Hülsen mit einer Kunststoff- oder Kautschukschicht oder einer Umhüllung aus einem textilen Gewirke. Als Unterlagen können auch Elemente mit einer auf einem dimensionsstabilen Träger, beispielsweise aus Metall oder Kunststoff, aufgebrachten, festen, lichtempfindlichen, insbesondere photopolymerisierbaren, Schicht dienen, wodurch es mit dem erfindungsgemäßen Verfahren beispielsweise möglich ist, Formzylinder oder Formzylinder-Hülsen, wie sie für den Rotationsdruck eingesetzt werden, auch mit mehreren Lagen von lichtempfindlichen Schichten gleicher oder verschiedener Art durchgehend und nahtlos zu belegen.

Erfindungsgemäß können die Endbereiche nur einer lichtempfindlichen Schicht miteinander verbunden werden, indem diese so um einen Zylinder, eine zylindrische oder konisch zulaufende Hülse oder dergleichen herumgelegt wird, daß sich ihre Endbereiche überlappen. Es können gleichermaßen auch die Seitenbereiche nur einer lichtempfindlichen Schicht haftfest und nahtlos miteinander verbunden werden, wenn die bahn- oder bandförmige lichtempfindliche Schicht spiralförmig so um einen Zylinder, um eine zylindrische oder konisch zulaufende Hülse oder dergleichen herumgewickelt wird, daß ihre Seitenbereiche überlappen. Ebenso ist es möglich, erfindungsgemäß die End- und/oder Seitenbereiche von zwei oder mehreren hintereinander und/oder nebeneinander auf einer Unterlage aufgebrachten lichtempfindlichen Schichten miteinander zu verbinden. Treten dabei zwei oder mehr Überlappungen der End- und/oder Seitenbereiche auf, so können diese Überlappungen dachziegelartig oder schichtweise versetzt angeordnet sein. Im letztgenannten Fall werden z.B. jeweils zwei nebeneinanderliegende End- oder Seitenbereiche von lichtempfindlichen Schichten von einer weiteren, beispielsweise streifenförmig ausgebildeten, lichtempfindlichen Schicht überdeckt. Das Ausmaß der Überlappung, mit dem die End- und/oder Seitenbereiche der lichtempfindlichen Schichten erfindungsgemäß zum haftfesten Verbinden übereinander gelegt werden, soll mindestens so groß sein, daß nach der Wärme- und Druckbehandlung eine haftfeste, mechanisch bearbeitbare Verbindung resultiert, ist im übrigen jedoch nicht kritisch. Im allgemeinen beträgt der Überlappungsbereich an einer Verbindungsstelle nicht mehr als 50 % der Schichtfläche, insbesondere nicht mehr als 25 % der Fläche einer Schicht. Es hat sich gezeigt, daß für die praktische Anwendung Überlappungen im Bereich von etwa 1 bis 10 cm Breite sinnvoll und günstig sind.

Zur Durchführung des erfindungsgemäßen Verfahrens werden die End- und/oder Seitenbereiche der zu verbindenden lichtempfindlichen Schichten in dem Überlappungsbereich blasenfrei unter Verdrängung der Luft unter dem hierbei die obere Lage bildenden End- bzw. Seitenbereich zusammengelegt. Das bedeutet, daß nicht nur der unmittelbare Überlappungsbereich, in dem die zu verbindenden End- oder Seitenbereiche der lichtempfindlichen Schichten direkt aufeinanderliegen, frei von Blasen und Lufteinschlüssen sein soll, sondern daß auch in dem angrenzenden Bereich, wo die zu verbindenden End- bzw. Seitenbereiche aufeinanderstoßen, unter der lichtempfindlichen Schicht, die beim überlappenden Zusammenlegen zu oberst zu liegen kommt, die Luft verdrängt und hierunter praktisch kein Lufthohlraum gebildet wird. Dies kann beispielsweise durch entsprechendes luftverdrängendes Andrücken, z.B. mittels einer Walze, der im Überlappungsbereich die obere Lage bildenden lichtempfindlichen Schicht erfolgen. Um an der Stoßlinie der zu verbindenden End- und/oder Seitenbereiche ein gutes Anschmiegen der die obere Lage der Überlappung bildenden Schicht an die Kante der die untere Lage der Überlappung bildenden Schicht unter Vermeidung der Ausbildung eines Lufthohlraumes in diesem Bereich zu gewährleisten und sicherzustellen, kann es empfehlenswert und hilfreich sein, das vorerwähnte Andrücken der Schicht beim überlappenden Zusammenlegen unter Mitverwendung eines üblichen Kaschierhilfsmittels und/oder insbesondere unter dem Einfluß von Wärme durchzuführen.

Zum haftfesten Verbinden der so blasenfrei auf einer Unterlage überlappend zusammengelegten End- und/oder Seitenbereiche der lichtempfindlichen Schichten wird erfindungsgemäß anschließend die gesamte lichtempfindliche Schichtmasse unter dem Einfluß von Druck solange erwärmt, bis die überlappend zusammengelegten End- und/oder Seitenbereiche haftfest miteinander verbunden sind und sich eine zusammenhängende, durchgehende lichtempfindliche Schicht gebildet hat. Die hierbei anzuwendenden Temperaturen richten sich in erster Linie nach den thermischen und rheologischen Eigenschaften der eingesetzten lichtempfindlichen Schichten und liegen dabei mindestens so hoch, daß unter dem einwirkenden Druck die überlappend zusammengelegten End- und/oder Seitenbereiche miteinander verkleben bzw. ineinander verfließen, jedoch nicht so hoch, daß hierdurch die Eigenschaften der lichtempfindlichen Schichten beeinträchtigt würden. Im übrigen werden die Temperaturen so gewählt, daß das Verbinden der End- und/oder Seitenbereiche in angemessener Zeit abläuft. Üblicherweise werden Temperaturen von etwa 40 bis 200°C, insbesondere Temperaturen im Bereich von etwa 80 bis 150°C, angewandt. Die Erwärmung der Schichtmasse kann dabei rückseitig, d.h. von der auf der Unterlage aufliegenden Schichtseite her, erfolgen, beispielsweise durch in der Unterlage angeordnete Heizelemente. Für solche Heizelemente sind insbesondere elektrische Widerstandsheizungen geeignet. Es ist aber auch möglich, die Erwärmung der Schichtmasse von der äußeren Schichtoberfläche her vorzunehmen, beispielsweise mittels Infrarot-, Mikrowellenstrahler, Heißluftgebläsen oder dergleichen. Selbstverständlich können auch beide Methoden des Erwärmens, rückseitig und von der äußeren Schichtoberfläche her, gleichzeitig durchgeführt werden.

Der während des Erwärmens der lichtempfindlichen Schichten auf die Schichtoberfläche wirkende Druck kann an sich in jeder beliebigen geeigneten Weise erzeugt werden. Beispielsweise kann hierfür ein festes Druckelement, dessen Form an die Oberflächenform der Unterlage angepaßt ist, wie z.B. ein Stempel oder dergleichen, eingesetzt werden. Wenn die lichtempfindlichen Schichten zum Verbinden ihrer End- und/oder Seitenbereiche auf einem Formzylinder oder einer Zylinder-Hülse, einschließlich konisch zulaufender Zylinder-Hülsen, aufgebracht sind, hat sich zur Druckerzeugung das Anlegen eines Vakuums zwischen Formzylinder bzw. Zylinder-Hülse einerseits und lichtempfindlicher Aufzeichnungsschicht bzw. lichtempfindlichen Aufzeichnungsschichten andererseits unter Absaugen von Luft und evtl. vorhandenen sonstigen Gasen als besonders einfach und vorteilhaft erwiesen. Dieses kann in an sich bekannter Weise erfolgen, beispielsweise durch gasdichtes Umhüllen der auf dem Formzylinder oder der Zylinderhülse überlappend zusammengelegten lichtempfindlichen Schichten mit einer Kunststoffolie oder Schrumpffolie und Evakuieren, wobei die Unterlage mit entsprechenden Absaugöffnungen oder oberflächlichen, das Absaugen von Gasen zwischen lichtempfindlicher Schicht und Unterlage ermöglichenden Kanälen oder dergleichen versehen ist. In diesem Zusammenhang sei auf den vorgehend zitierten Stand der Technik verwiesen. In einer möglichen, vorteilhaften Ausgestaltungsform des erfindungsgemäßen Verfahrens wird hierzu der Formzylinder bzw. die Zylinderhülse, die mit einer Haftschicht versehen sein können, mit einem textilen Gewirke umhüllt, bevor hierauf die lichtempfindlichen Schichten in ihren End- und/oder Seitenbereichen überlappend zusammengelegt werden und anschließend nach gasdichter Umhüllung mit einer Kunststoff-Folie Vakuum angelegt wird.

Die Zeit für die Wärme- und Druckbehandlung der in ihren End- und/oder Seitenbereichen überlappend zusammengelegten lichtempfindlichen Schichten für das haftfeste Verbinden hängt im wesentlichen von der Art der lichtempfindlichen Schichten und den Verfahrensbedingungen ab und liegt üblicherweise im Bereich von etwa 10 bis 120 Minuten.

Durch das Erwärmen unter Druck wird eine haftfeste Verbindung der überlappend zusammengelegten End- und/oder Seitenbereiche der lichtempfindlichen Schichten bewirkt. Nach Abkühlen wird im Anschluß daran die so erhaltene durchgehend verbundene lichtempfindliche Schicht einer maßgenauen, formgebenden, insbesondere mechanischen, Nachbehandlung unterzogen. Für diese formgebende Nachbehandlung verbleiben die in ihren End- und/oder Seitenbereichen verbundenen, durchgehenden lichtempfindlichen Schichten im allgemeinen und vorteilhafterweise auf der festen Unterlage, auf der sie für das haftfeste Verbinden der End- und/oder Seitenbereiche aufgebracht worden waren.

Die formgebende Nachbehandlung dient insbesondere der Erzeugung einer maßgenauen, durchgehenden, gleichmäßigen nahtlosen lichtempfindlichen Schicht. Die formgebende Nachbehandlung bewirkt dabei nicht nur den Ausgleich von Schwankungen in der Schichtoberfläche, sondern sie ist z.B. insbesondere bedeutungsvoll für die Erzielung eines exakt zylindrischen Umfangs, wenn die zu verbindenden lichtempfindlichen Schichten auf Formzylinder oder Zylinderhülsen, einschließlich konisch zulaufender Zylinderhülsen, aufgebracht werden und nach der Erzeugung der durchgehend verbundenen lichtempfindlichen Schicht zur Herstellung von Druckzylindern oder Druckzylinder-Hülsen verwendet werden sollen. Insbesondere im Fall von konisch zulaufenden Zylinderhülsen als Unterlage muß nämlich durch die formgebende Nachbehandlung auch die längenaxiale Ab- bzw. Zunahme im Durchmesser der Hülse ausgeglichen werden. Die formgebende Nachbehandlung kann nach an sich jeder geeigneten Methode erfolgen und wird vorzugsweise durch mechanische Bearbeitung der Oberfläche der lichtempfindlichen Schicht, wie z.B. Abdrehen, Abspänen, Schleifen oder dergleichen, vorgenommen. Die Glättung der Oberfläche der so nachbehandelten, durchgehend verbundenen gleichmäßigen lichtempfindlichen Schicht kann nach an sich bekannten und üblichen Verfahrensweisen, beispielsweise durch Lösungsmittelbehandlung, mittels Glättwalzen oder dergleichen, erfolgen. Die formgebende Nachbehandlung und Glättung kann auch eine geeignete thermische Behandlung beinhalten, wie z.B. Heißkalandrieren.

Die erfindungsgemäß hergestellten, durchgehenden, nahtlosen, gleichmäßigen lichtempfindlichen Schichten können für die verschiedensten Anwendungen, beispielsweise als Überzüge für die Herstellung von Resistmustern oder dekorativen Reliefoberflächen, eingesetzt werden. Insbesondere können sie aber für die Herstellung von Druckformen, insbesondere Flexodruckformen oder Tiefdruckformen, nach den an sich bekannten Verfahren der bildmäßigen Belichtung mit aktinischem Licht und Entwicklung Verwendung finden. Dabei können die nach dem erfindungsgemäßen Verfahren verbundenen, durchgehenden lichtempfindlichen Schichten vor ihrer weiteren Verarbeitung und Verwendung mit Schutzfolien, Lackschichten, mattierten Folien oder dergleichen überzogen werden.

Insbesondere eignet sich das erfindungsgemäße Verfahren zur Herstellung von mit durchgehenden, nahtlosen lichtempfindlichen Schichten beschichteten Zylindern oder Zylinderhülsen, wie sie für die Herstellung von Druckformen und Druckzylindern für den Rotationsdruck, insbesondere im Endlosdruck, verwendet werden.

Die Erfindung wird durch die nachfolgenden Beispiele näher erläutert.

Beispiel 1

Eine trägerfreie, rechteckige, lichtempfindliche, photopolymerisierbare Schicht einer Dicke von 0,5 mm, hergestellt aus den Komponenten gemäß Vergleichsversuch A der EP-A-70 510, für die Herstellung von photopolymeren Tiefdruckformen wurde so um eine mit einer Haftschicht versehene zylindrische Nickel-Hülse gewickelt, daß die beiden achsparallelen Kanten der Schicht sich um etwa 2 cm überlappten. Nach Umhüllung mit einer gasdichten Folie und Erzeugung eines Unterdrucks zwischen lichtempfindlicher Schicht und Oberfläche der Nickel-Hülse wurde die gesamte lichtempfindliche Schicht für etwa 30 Minuten auf 130°C erwärmt. Danach war sowohl die lichtempfindliche Schicht fest mit der Nickel-Hülse verbunden, als auch waren die überlappenden Endbereiche der lichtempfindlichen Schicht unter Verschmelzung vollständig und fest miteinander verbunden. Nach dem Abkühlen der Schicht und Entfernen der gasdichten Folie wurde die Oberfläche der in ihren Endbereichen verbundenen lichtempfindlichen Schicht durch Abdrehen mit einem Hartmetall-Werkzeug auf das gewünschte zylindrische Maß gebracht. Schließlich wurde durch Schleifen und Heißkalandrieren die Schichtoberfläche geglättet. Es resultierte eine Zylinderhülse mit einer durchgehenden nahtlosen, glatten und gleichmäßigen lichtempfindlichen Schicht. Gemäß dem Verfahren von Beispiel 1 der EP-A-70 510 konnte hieraus durch bildmäßiges Belichten mit aktinischem Licht und Entwickeln mit einem Entwicklerlösungsmittel eine einwandfreie Druckform für den Rotationstiefdruck hergestellt werden.

Beispiel 2

Es wurde entsprechend wie in Beispiel 1 gearbeitet, diesmal jedoch eine 0,8 mm dicke, rechteckige, photopolymerisierbare Schicht sonst gleicher Zusammensetzung um eine leicht konische Nickel-Hülse gewickelt. Die beiden achsparallel laufenden, sich ca. 3 cm überlappenden Endabschnitte der photopolymerisierbaren Schicht waren im Überlappungsbereich keilförmig abgeschrägt. Die konische Nickel-Hülse war diesmal zur Erleichterung des Absaugens von Gasen zur Erzeugung des Unterdrucks vor dem Umwickeln mit der photopolymerisierbaren Schicht mit einem feinmaschigen Strumpf aus Kunstfaser überzogen worden. Nach Verbinden der Endbereiche der photopolymerisierbaren Schicht sowie Abdrehen und Glätten der Schichtoberfläche wie in Beispiel 1 wurde eine mit einer nahtlosen lichtempfindlichen Schicht versehene, exakt zylindrische Druckzylinder-Hülse erhalten, aus der durch Belichten mit aktinischem Licht und Entwickeln mit einem Entwicklerlösemittel eine Tiefdruckform für den Endlosdruck hergestellt werden konnte.

Beispiel 3

Eine 0,7 mm dicke, rechteckige, photopolymerisierbare Schicht auf Basis eines alkohollöslichen Polyamids entsprechend Beispiel 1 der EP-A-46 047 wurde in gleicher Weise wie in Beispiel 2 beschrieben auf eine Zylinder-Hülse aufgebracht, die dieses Mal jedoch aus einem Phenol-Harz bestand. Nach dem Verbinden der Endbereiche der lichtempfindlichen Schicht, Schleifen und Glätten der Schichtoberfläche wie in Beispiel 2 wurde eine exakt zylindrische Hülse erhalten, deren nahtlose, glatte, photopolymerisierbare Schicht bildmäßig mit aktinischem Licht belichtet und anschließend entwickelt wurde. Die erhaltene Druckform lieferte ausgezeichnete Ergebnisse im rotativen Hochdruck.

Beispiel 4

Eine für die Herstellung von Hochdruckformen geeignete, 0,5 mm starke photopolymerisierbare Schicht, die gemäß Beispiel 4 der EP-A-10 690 hergestellt wurde, wurde wie in Beispiel 1 beschrieben auf eine zylindrische Hülse aus glasfaserverstärktem Polyester aufgebracht und weiter verarbeitet. Die resultierende, exakt zylindrische Hülse mit glatter, nahtloser Oberfläche aus der photopolymerisierbaren Schicht wurde in üblicher Weise bildmäßig mit aktinischem Licht belichtet und zu einer Druckform mit hervorragenden Eigenschaften entwickelt.

Beispiel 5

Eine 1,2 mm starke, rechteckig zugeschnittene, photopolymerisierbare Schicht gemäß Beispiel 1 DE-A-29 42 183 wurde auf eine mit einem Haftlack versehene, konische Nickel-Hülse so aufgebracht, daß sich die keilförmig abgeschrägten Endbereiche etwa 2 cm überlappten. Durch Erwärmen unter Druck wurden die Schichtenden im Überlappungsbereich miteinander verschmolzen. Danach wurde durch Schleifen und Kalandrieren eine exakt zylindrische glatte Oberfläche erzeugt. Die so erhaltene Zylinder-Hülse war für die Herstellung von Flexodruckformen geeignet.

**Patentansprüche**

1. Verfahren zum nahtlosen und haftfesten Verbinden der End- und/oder Seitenbereiche von thermoplastisch verarbeitbaren lichtempfindlichen Schichten unter dem Einfluß von Wärme und Druck, dadurch gekennzeichnet, daß die End- und/oder Seitenbereiche von einer bzw. mehreren im wesentlichen lösungsmittelfreien und trägerfreien lichtempfindlichen Schichten blasenfrei unter Verdrängung der Luft zwischen den End- bzw. Seitenbereichen überlappend zusammengelegt werden, danach die gesamte Schichtmasse unter Druck und Verbinden der sich überlappenden End- und/oder Seitenbereiche erwärmt und die so erhaltene durchgehend verbundene lichtempfindliche Schicht unter maßgenauer Formgebung nachbehandelt und geglättet wird.

2. Verfahren nach Anspruch 1, dadurch gekennzeichnet, daß mindestens einer der zu verbindenden End- und/oder Seitenbereiche, vorzugsweise mindestens der im Überlappungsbereich die untere Lage bildende End- und/oder Seitenbereich, keilförmig abgeschrägt ist.

3. Verfahren nach Anspruch 2, dadurch gekennzeichnet, daß bei dem in dem Überlappungsbereich die untere Lage bildenden End- und/oder Seitenbereich die keilförmige Abschrägung von der darüberliegenden Schicht weg nach unten hin gerichtet ist.

4. Verfahren nach einem der Ansprüche 1 bis 3, dadurch gekennzeichnet, daß solche lösungsmittelfreien, thermoplastisch verarbeitbaren lichtempfindlichen Schichten eingesetzt werden, die unter den Verarbeitungsbedingungen nicht gasen.

5. Verfahren nach einem der Ansprüche 1 bis 4, dadurch gekennzeichnet, daß die im Überlappungsbereich die obere Lage bildende lichtempfindliche Schicht unter luftverdrängendem Andrücken an den End- und/oder Seitenbereich der im Überlappungsbereich die untere Lage bildenden lichtempfindlichen Schicht mit diesem zusammengelegt wird.

6. Verfahren nach einem der Ansprüche 1 bis 5, dadurch gekennzeichnet, daß das überlappende Zusammenlegen der End- und/oder Seitenbereiche der lichtempfindlichen Schichten unter dem Einfluß von Wärme und/oder unter Mitverwendung eines Kaschierhilfsmittels erfolgt.

7. Verfahren nach einem der Ansprüche 1 bis 6, dadurch gekennzeichnet, daß sich die zu verbindenden End- und/oder Seitenbereiche etwa 1 bis 10 cm überlappen.

8. Verfahren nach einem der Ansprüche 1 bis 7, dadurch gekennzeichnet, daß die Schichtmasse zum Verbinden der sich überlappenden End-und/oder Seitenbereiche auf eine Temperatur im Bereich von etwa 80 bis 150 °C erwärmt wird.

9. Verfahren nach einem der Ansprüche 1 bis 8, dadurch gekennzeichnet, daß der Druck etwa 0,1 bis 1 kg/cm$^2$ beträgt.

10. Verfahren nach einem der Ansprüche 1 bis 9, dadurch gekennzeichnet, daß die lichtempfindlichen Schichten vor dem Verbinden ihrer End- und/oder Seitenbereiche auf eine formstabile Unterlage aufgebracht werden.

11. Verfahren nach Anspruch 10, dadurch gekennzeichnet, daß es sich bei der Unterlage um einen Zylinder, eine zylindrische Hülse oder eine konisch zulaufende Hülse aus Metall, Kunststoff oder glasfaserverstärktem Kunststoff handelt.

12. Verfahren nach einem der Ansprüche 10 oder 11, dadurch gekennzeichnet, daß das Erwärmen zum Verbinden der sich überlappenden End- und/oder Seitenbereiche der lichtempfindlichen Schichten unter Einwirkung eines Vakuums zwischen Unterlage und lichtempfindlicher Schicht bzw. einer sie abdeckenden Kunststoff-Folie oder Schrumpffolie erfolgt.

13. Verfahren nach einem der Ansprüche 1 bis 12, dadurch gekennzeichnet, daß eine bahnförmige lichtempfindliche Schicht eingesetzt wird, die so um einen Formzylinder oder eine, gegebenenfalls konisch zulaufende, Zylinderhülse gewickelt wird, daß sich die Endabschnitte der bahnförmigen lichtempfindlichen Schicht überlappen.

14. Verfahren nach einem der Ansprüche 1 bis 13, dadurch gekennzeichnet, daß die maßgenaue formgebende Nachbehandlung mechanisch durch Abdrehen, Abspänen oder Schleifen erfolgt.

15. Verfahren nach einem der Ansprüche 1 bis 14, dadurch gekennzeichnet, daß auf einem Formzylinder oder einer, gegebenenfalls konisch zulaufenden Zylinderhülse eine durchgehende, nahtlose, gleichmäßige lichtempfindliche Schicht mit exakt zylindrischer äußerer Oberfläche geformt wird.

16. Verwendung der nach einem der Ansprüche 1 bis 15 hergestellten, verbundenen, durchgehenden lichtempfindlichen Schicht zur Herstellung von Hochdruckformen, insbesondere Flexodruckformen.

17. Verwendung der nach einem der Ansprüche 1 bis 15 hergestellten, verbundenen, durchgehenden lichtempfindlichen Schicht für die Herstellung von Tiefdruckformen.

## Claims

1. A process for the seamless and firm joining of the end and/or lateral areas of thermoplastically processable photosensitive layers under the influence of heat and pressure, wherein the end and/or lateral areas of one or more essentially solvent-free and base-free photo-sensitive layers are overlapped avoiding bubbles and with displacement of the air between the end and lateral areas, the total layer material is then heated under pressure and with joining of the overlapping end and/or lateral areas, and the resulting continuously joined photosensitive layer is aftertreated and smoothed with shaping to exact size.

2. A process as claimed in claim 1, wherein one or more of the end and/or lateral areas to be joined, preferably at least the end and/or lateral area forming the lower stratum in the overlap area, is wedge-shaped.

3. A process as claimed in claim 2, wherein, in the end and/or lateral area forming the lower stratum in the overlap area, the wedge-shaped bevel is directed downward and away from the layer on top.

4. A process as claimed in any of claims 1 to 3, wherein the solvent-free, thermoplastically processable photosensitive layers used are those which do not form gas under the processing conditions.

5. A process as claimed in any of claims 1 to 4, wherein the photosensitive layer forming the upper stratum in the overlapping area is united with the end and/or lateral area of the photosensitive layer forming the lower stratum in the overlap area, with displacement of air by pressing.

6. A process as claimed in any of claims 1 to 5, wherein overlapping of the end and/or lateral areas of the photosensitive layers is carried out under the influence of heat and/or in the presence of a laminating assistant.

7. A process as claimed in any of claims 1 to 6, wherein the end and/or lateral areas to be joined overlap by about 1-10 cm.

8. A process as claimed in any of claims 1 to 7, wherein the layer material is heated to about 80-150° C for joining the overlapping end and/or lateral areas.

9. A process as claimed in any of claims 1 to 8, wherein the pressure is about 0.1-1 kg/cm$^2$.

10. A process as claimed in any of claims 1 to 9, wherein the photosensitive layers are applied to a dimensionally stable substrate before their end and/or lateral areas are joined.

11. A process as claimed in claim 10, wherein the substrate is a cylinder, a cylindrical sleeve or a conical sleeve of metal, plastic or glass fiber-reinforced plastic.

12. A process as claimed in claim 10 or 11, wherein heating for joining the overlapping end and/or lateral areas of the photosensitive layers is carried out under reduced pressure between the substrate and the photo-sensitive layer or under a plastic film or shrink film covering the said layers.

13. A process as claimed in any of claims 1 to 12, wherein a web-like photosensitive layer is used, the said layer being wound around a plate cylinder or a sleeve, which may be conical, in such a way that the end sections of the web-like photosensitive layer overlap.

14. A process as claimed in any of claims 1 to 13, wherein the shaping aftertreatment to give exact dimensions is carried out mechanically by turning, cutting or grinding.

15. A process as claimed in any of claims 1 to 14, wherein a continuous, seamless, uniform photosensitive layer having an exact cylindrical outer surface is formed on a plate cylinder or a sleeve, which may be conical.

16. The use of a joined-together, continuous photosensitive layer produced as claimed in any of claims 1 to 15, for producing letterpress printing plates, in particular flexographic printing plates.

17. The use of a joined-together, continuous photosensitive layer produced as claimed in any of claims 1 to 15, for producing intaglio printing plates.

## Revendications

1. Procédé pour souder solidement et sans joint les régions terminales et/ou latérales de couches photosensibles aptes au travail thermoplastique sous l'action de la chaleur et de la pression, caractérisé en ce que l'on assemble avec chevauchement les régions terminales et/ou latérales d'une ou plusieurs couches photosensibles essentiellement exemptes de solvant et sans support, sans former de bulles, en refoulant l'air entre les régions terminales et les régions latérales, on chauffe ensuite toute la masse des couches sous pression, avec soudure des régions terminales et/ou latérales qui se chevauchent puis on soumet la couche photosensible entièrement soudée ainsi obtenue à traitement de façonnage conforme aux mesures et on la lisse.

2. Procédé selon la revendication 1, caractérisé en ce que l'une au moins des régions terminales et/ou latérales à souder, de préférence au moins la région terminale et/ou latérale qui forme la couche inférieure dans la région de chevauchement, est taillée en biseau.

3. Procédé selon la revendication 2, caractérisé en ce que dans la région terminale et/ou latérale formant la couche inférieure dans le domaine de chevauchement, la taille en biseau est dirigée de la couche supérieure vers le bas et vers l'extérieur.

4. Procédé selon l'une des revendications 1 à 3, caractérisé en ce que l'on utilise des couches photosensibles exemptes de solvant, aptes au travail thermoplastique, qui ne dégagent pas de gaz dans les conditions opératoires.

5. Procédé selon l'une des revendications 1 à 4, caractérisé en ce que l'on assemble la couche photosensible formant la couche supérieure dans la région du chevauchement avec la couche photosensible formant la couche inférieure dans la région du chevauchement en pressant et en refoulant l'air sur la région terminale et/ou latérale de cette couche.

6. Procédé selon l'une des revendications 1 à 5, caractérisé en ce que l'assemblage avec chevauchement des régions terminales et/ou latérales des couches photosensibles est réalisé sous l'action de la chaleur et/ou avec utilisation conjointe d'un produit auxiliaire de doublage.

7. Procédé selon l'une des revendications 1 à 6, caractérisé en ce que les régions terminales et/ou latérales à souder se chevauchent d'environ 1 à 10 cm.

8. Procédé selon l'une des revendications 1 à 7, caractérisé en ce que, pour souder les régions terminales et/ou latérales qui se chevauchent, on chauffe la masse des couches à une température dans l'intervalle de 80 à 150 degrés C environ.

9. Procédé selon l'une des revendications 1 à 8, caractérisé en ce que la pression est d'environ 0,1 à 1 kg/cm$^2$.

10. Procédé selon l'une des revendications 1 à 9, caractérisé en ce que, avant soudage des régions terminales et/ou latérales, les couches photosensibles sont appliquées sur un support de forme stable.

11. Procédé selon la revendication 10, caractérisé en ce que le support est un cylindre, un manchon cylindrique ou un manchon à extrémités coniques en métal, en résine synthétique ou en résine synthétique renforcée par des fibres de verre.

12. Procédé selon l'une des revendications 10 ou 11, caractérisé en ce que le chauffage pour soudage des régions terminales et/ou latérales des couches photosensibles qui se chevauchent est réalisé sous l'action d'un vide entre le support et la couche photosensible ou une feuille de résine synthétique ou feuille rétractable qui la recouvre.

13. Procédé selon l'une des revendications 1 à 12, caractérisé en ce que l'on utilise une couche photosensible sous forme d'une pièce continue que l'on enroule autour d'un cylindre de forme ou d'un manchon de cylindre éventuellement à extrémités coniques en sorte que les sections terminales de la couche photosensible à l'état de pièce se chevauchent.

14. Procédé selon l'une des revendications 1 à 13, caractérisé en ce que le traitement subséquent de façonnage aux mesures est réalisé mécaniquement par tournage, enlèvement de copeaux ou meulage.

15. Procédé selon l'une des revendications 1 à 14, caractérisé en ce que, sur un cylindre de forme ou un manchon de cylindre à extrémités éventuellement coniques, on forme une couche photosensible complète, sans joint, uniforme, à surface extérieure exactement cylindrique.

16. Utilisation de la couche photosensible soudée, continue, préparée selon l'une des revendications 1 à 15, pour la fabrication de formes d'impression en relief, en particulier de formes d'impression flexographiques.

17. Utilisation de la couche photosensible soudée, continue, préparée selon l'une des revendications 1 à 15, pour la préparation de formes d'impression en creux.